# FASCICULE DE BREVET EUROPEEN

(11) **EP 3 214 661 B1**
(45) Date de publication et mention de la délivrance du brevet: **23.03.2022**
(21) Numéro de dépôt: 17156710.0
(22) Date de dépôt: 17.02.2017
(51) Int. Cl.: H01L 33/08, H01L 33/24, H01L 31/12, F21S 41/155, B60Q 1/08, F21S 43/145

(54) **SOURCE DE LUMIERE A SEMI-CONDUCTEURS POUR L'EMISSION ET LA RECEPTION DE FAISCEAUX LUMINEUX, ET SYSTEME LUMINEUX COMPORTANT UNE TELLE SOURCE**
LICHTQUELLE MIT HALBLEITERN ZUM AUSSTRAHLEN UND EMPFANGEN VON LICHTSTRAHLEN, UND LEUCHTSYSTEM, DAS EINE SOLCHE QUELLE UMFASST
SEMICONDUCTOR LIGHT SOURCE FOR EMITTING AND RECEIVING LIGHT BEAMS, AND LIGHTING SYSTEM COMPRISING SUCH A SOURCE

(30) Priorité: 02.03.2016 FR 1651751
(43) Date de publication de la demande: 06.09.2017
(73) Titulaire: Valeo Vision, 93012 Bobigny Cedex (FR)
(72) Inventeur: LE-CALVEZ, Gilles, 92500 RUEIL-MALMAISON (FR); ALBOU, Pierre, 75013 PARIS (FR); REISS, Benoit, 95580 MAGENCY (FR)
(74) Mandataire: Valeo Visibility

(56) Documents cités:
- EP-A1- 2 357 676
- EP-A1- 2 819 326
- DE-A1-102013 104 273
- US-A1- 2013 190 971

## Description

La présente invention concerne de manière générale les systèmes d'émission et de réception de faisceaux lumineux aptes à être utilisés notamment pour la communication de données ou la détection d'objets.

Dans le domaine particulier et non limitatif de l'automobile, il est connu d'utiliser de tels dispositifs pour permettre un échange bidirectionnel de données :
- à l'intérieur de l'habitacle d'un véhicule, par exemple entre un dispositif placé dans un plafonnier et une tablette numérique ou tout appareil de communication portatif adapté, via une communication Li-Fi (Acronyme anglo-saxon mis pour « Light Fidelity ») ;
- entre deux véhicules, par exemple entre l'arrière et l'avant de deux véhicules qui se suivent (« Car-to-car communications ») ;
- entre un véhicule et l'infrastructure routière (« Car-to-Infrastructure » ou « Car-to-X » communications).

Il est également connu d'utiliser ce type de dispositifs comme capteurs, avec différentes finalités possibles (capteur de pluie, capteur de luminosité ambiante, capteur de visibilité, capteur de salissure notamment de la glace d'un projecteur d'éclairage).

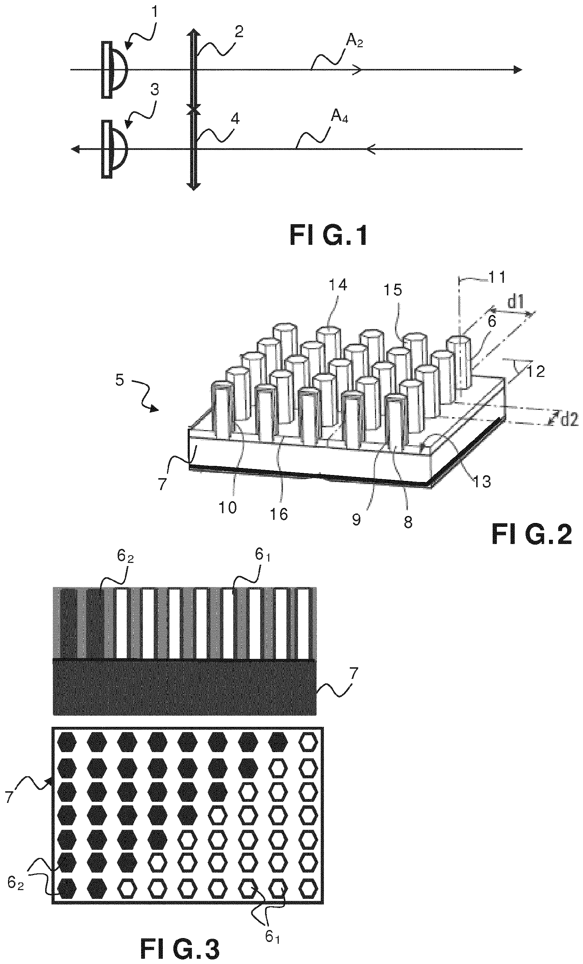

Dans tous les cas connus, les dispositifs d'émission et de réception des faisceaux lumineux comportent des diodes électroluminescentes différentes pour l'émission et la réception à des longueurs d'ondes similaires ou identiques. Chaque diode électroluminescente est en outre associée à un dispositif optique dédié, avec sa propre focale, destiné, dans le cas de la diode d'émission, à répartir, et dans le cas de la diode de réception à concentrer correctement le faisceau lumineux. Cela est d'autant plus important pour un dispositif utilisé pour une communication Li-Fi car il est nécessaire dans ce cas de disposer de canaux d'émission et de réception simultanés. La figure 1 illustre schématiquement les composantes d'un dispositif connu, avec une première diode électroluminescente 1 pour l'émission à une première longueur d'onde et son dispositif optique 2 associé d'axe optique A₂, et une deuxième diode de type photodiode 3 pour la réception à une deuxième longueur d'onde sensiblement égale à la première longueur d'onde, et son dispositif optique 4 associé d'axe optique A₄.

Dans d'autres solutions connues, un dispositif optique unique mais complexe, disposant de deux axes optiques distincts, peut être mis en regard des deux diodes 1 et 3 aux mêmes fins.

La diode électroluminescente 1 est par exemple une diode conventionnelle comprenant un substrat, généralement en arséniure de Gallium, sur lequel on vient déposer les couches actives en sélectionnant le semi-conducteur selon la longueur d'onde de fonctionnement souhaitée. La photodiode 3 est par exemple à base de silicium.

Un aspect de l' invention a pour objet une source de lumière à semiconducteur selon la revendication 1.

Selon d'autres caractéristiques avantageuses :
- la deuxième longueur d'onde est de préférence strictement supérieure à la première longueur d'onde, la deuxième longueur d'onde étant de préférence dans le spectre non visible;
- dans un mode de réalisation possible, la deuxième longueur d'onde est sensiblement égale à la première longueur d'onde ;
- la première longueur d'onde et la deuxième longueur d'onde sont par exemple choisies dans le spectre visible ;
- en variante, la première longueur d'onde et la deuxième longueur d'onde sont choisies dans l'infrarouge, de préférence entre 780 nanomètres et 1,5 micromètres ;
- les sources à semi-conducteur en trois dimensions du premier ensemble et les sources à semi-conducteur en trois dimensions du deuxième ensemble peuvent avantageusement être répartis de sorte que le premier ensemble et le deuxième ensemble forment deux zones enchevêtrées ; par enchevêtrées, on entend que pour chacune des zones, il existe au moins un couple de sources à semi-conducteur en trois dimensions reliés par un segment intersectant l'autre zone. - les sources à semi-conducteur en trois dimensions sont de préférence séparés deux à deux d'une distance inférieure ou égale à 30 microns, par exemple inférieure ou égale à 10 microns.

La présente invention a également pour objet un système d'émission/réception de faisceaux lumineux, caractérisé en ce qu'il comporte au moins une source de lumière telle que définie précédemment, et une même optique de mise en forme associée à la zone d'émission et à la zone de réception de ladite source de lumière.

Ladite au moins une source de lumière et l'optique de mise en forme associée sont placés par exemple dans un dispositif d'éclairage et/ou de signalisation d'un véhicule automobile, le système comportant en outre un dispositif de commande apte à activer indépendamment la zone d'émission et la zone de réception, en simultané et/ou en alternance. Le système peut ainsi être utilisé dans de nombreuses applications, à des fins de détection et/ou de communication.

Dans une application possible, les sources à semi-conducteur en trois dimensions du premier ensemble, respectivement du deuxième ensemble, sont aptes à émettre, respectivement recevoir, des signaux de communication.

Le dispositif d'éclairage et/ou de signalisation est par exemple un plafonnier dans l'habitacle d'un véhicule automobile.

Le dispositif d'éclairage et/ou de signalisation peut être également un projecteur, un feu de signalisation, ou un feu arrière de signalisation d'un véhicule automobile. Dans ce cas, les sources à semi-conducteur en trois dimensions du premier ensemble, respectivement du deuxième ensemble, peuvent être utilisés pour émettre, respectivement recevoir, des signaux de communication avec un autre véhicule automobile.

US 2013/190971 A1, DE 10 2013 104 273A1, EP 2 819 326 A1 et EP 2 357 676 A1 divulguent des sources de lumière à semiconducteur connues de l'art antérieur.

L'invention et ses avantages seront mieux compris au vu de la description qui suit, faite en référence aux figures annexées, dans lesquelles :
- la figure 1, déjà décrite ci-avant, illustre schématiquement un dispositif connu d'émission/réception de faisceaux lumineux ;
- la figure 2 illustre schématiquement le principe d'une source de lumière à semi-conducteur et bâtonnets de dimensions submillimétriques, avec une vue en perspective dans laquelle on a rendu visible en coupe une rangée de bâtonnets électroluminescents ;
- la figure 3 représente, en vue schématique de côté et de dessus, un premier exemple d'une source lumineuse à semi-conducteur et bâtonnets de dimensions submillimétriques conforme à la présente invention ;
- la figure 4 représente, en vue schématique de côté et de dessus, un autre exemple d'une source lumineuse à semi-conducteur et bâtonnets de dimensions submillimétriques conforme à la présente invention ;
- la figure 5 illustre schématiquement un système lumineux comportant une source de lumière selon l'invention.

Une source conforme à l'invention est une source de lumière à semiconducteur comprenant une pluralité de bâtonnets électroluminescents de dimensions submillimétriques, dans laquelle au moins certains bâtonnets sont connectés électriquement entre eux en un premier ensemble dédié à une émission d'un faisceau lumineux sensiblement à une première longueur d'onde, et d'autres bâtonnets sont connectés électriquement entre eux en un deuxième ensemble dédié à une réception d'un faisceau lumineux sensiblement à une deuxième longueur d'onde, le premier ensemble et le deuxième ensemble formant respectivement une zone d'émission et une zone de réception distinctes. Des exemples de configurations d'ensembles seront décrits à partir de la figure 3.

Dans le contexte de l'invention, un ensemble de bâtonnets émettant à une certaine longueur d'onde d'émission ne s'entend pas comme un ensemble de bâtonnets émettant strictement à une seule longueur d'onde comme une diode laser mais à l'intérieur d'un certain intervalle de longueur d'onde qui est de l'ordre de 10 nm.

On va dans un premier temps décrire la structure d'une source de lumière 5 à semi- conducteurs comportant des bâtonnets électroluminescents de dimensions submillimétriques en se référant notamment à la figure 2, laquelle figure ne montre pas les ensembles précités.

En référence à la figure 2, la source de lumière est une source 5 à semi-conducteur, comprenant une pluralité de bâtonnets électroluminescents 6 de dimensions submillimétriques, que l'on appellera par la suite bâtonnets électroluminescents, c'est-à-dire des sources à semi-conducteur en trois dimensions tel que cela sera exposé ci-après, contrairement aux sources classiques en deux dimensions, présentant des couches émissives sensiblement planes, alors qu'une source à bâtonnets électroluminescents présente des couches émissives sous la forme de reliefs en saillie.

Ces bâtonnets électroluminescents 6 prennent naissance de préférence sur un même substrat 7. Chaque bâtonnet électroluminescent, formé d'un même matériau semi-conducteur, par exemple du nitrure de gallium (GaN) pour une couleur bleue. Chaque bâtonnet s'étend perpendiculairement, ou sensiblement perpendiculairement, en saillie du substrat 7, par exemple réalisé à base de silicium, d'autres matériaux comme du carbure de silicium pouvant être utilisés pour le substrat sans sortir du contexte de l'invention. A titre d'exemple, les bâtonnets électroluminescents peuvent aussi être réalisés à partir d'un composé à base de nitrure d'aluminium et de gallium (AIGaN) notamment pour de émettre de l'ultraviolet.

Il s'agira encore par exemple d'arséniure de galium (AsGa) pour l'infrarouge ou d'un phosphore d'aluminium, d'indium et de Gallium (AlInGaP) pour du rouge.

Les bâtonnets électroluminescents 6 de dimensions submillimétriques s'étirent depuis le substrat 7 et comportent chacun un noyau 8 en nitrure de gallium, autour duquel sont disposés des puits quantiques 9 formés par une superposition radiale de couches de matériaux différents, par exemple du nitrure de gallium et du nitrure de gallium-indium, et une coque 10 entourant les puits quantiques également réalisée en nitrure de gallium.

Chaque bâtonnet s'étend selon un axe longitudinal 11 définissant sa hauteur, la base de chaque bâtonnet étant disposée dans un plan 12 de la face supérieure 13 du substrat 7.

Les bâtonnets électroluminescents 6 de la source de lumière à semiconducteur peuvent présenter la même forme. Ces bâtonnets sont chacun délimités par une face terminale 14 et par une paroi circonférentielle 15 qui s'étend le long de l'axe longitudinal. Lorsque les bâtonnets électroluminescents sont dopés et font l'objet d'une polarisation, la lumière résultante en sortie de la source à semi-conducteur est émise principalement à partir de la paroi circonférentielle 15, étant entendu que l'on peut prévoir que des rayons lumineux sortent également, au moins en petite quantité, à partir de la face terminale 14. Il en résulte que chaque bâtonnet 6 agit comme une unique diode électroluminescente et que la densité des bâtonnets électroluminescents améliore le rendement de cette source à semi-conducteur.

Différentes couches de matériaux sont superposées sur la face supérieure 13 du substrat, notamment après la croissance des bâtonnets électroluminescents depuis le substrat ici obtenue par une approche ascendante. Parmi ces différentes couches, on peut trouver au moins une couche de matériau conducteur électriquement, afin de permettre l'alimentation électrique des bâtonnets. Cette couche est gravée de manière à relier tel ou tel bâtonnet entre eux, l'allumage de ces bâtonnets pouvant alors être commandé simultanément par un module de commande ici non représenté.

La paroi circonférentielle 15 d'un bâtonnet 6, correspondant à la coquille de nitrure de gallium, est recouverte par une couche d'oxyde conducteur transparent (TCO) 16 qui forme l'anode de chaque bâtonnet complémentaire à la cathode formée par le substrat. Cette paroi circonférentielle 15 s'étend le long de l'axe longitudinal 11 depuis le substrat 7 jusqu'à la face terminale 14, la distance de la face terminale 14 à la face supérieure 13 du substrat, depuis laquelle prennent naissance les bâtonnets électroluminescents 6, définissant la hauteur de chaque bâtonnet. A titre d'exemple, on prévoit que la hauteur d'un bâtonnet électroluminescent 6 est comprise entre 1 et 10 micromètres, tandis que l'on prévoit que la plus grande dimension transversale de la face terminale, perpendiculairement à l'axe longitudinal 11 du bâtonnet électroluminescent concerné, soit inférieure à 2 micromètres. On pourra également prévoir de définir la surface d'un bâtonnet, dans un plan de coupe perpendiculaire à cet axe longitudinal 11, dans une plage de valeurs déterminées, et notamment entre 1 et 5 micromètres carré.

Ces dimensions, données à titre d'exemple non limitatif, permettent de démarquer une source de lumière à semi-conducteur comprenant des bâtonnets électroluminescents d'une source de lumière des sources à diodes sensiblement planes telle qu'utilisée précédemment.

On comprend que lors de la formation des bâtonnets 6, la hauteur peut être modifiée d'une source de lumière à l'autre, de manière à accroitre la luminance de la source de lumière à semi-conducteur lorsque la hauteur est augmentée. La hauteur des bâtonnets peut également être modifiée au sein d'une unique source de lumière, de sorte qu'un groupe de bâtonnets peut avoir une hauteur, ou des hauteurs, différentes d'un autre groupe de bâtonnets.

La forme des bâtonnets électroluminescents 6 peut également varier d'un dispositif à l'autre, notamment sur la section des bâtonnets et sur la forme de la face terminale 14. Il a été illustré sur la figure 2 des bâtonnets électroluminescents présentant une forme générale cylindrique, et notamment de section polygonale, ici plus particulièrement hexagonale. On comprend qu'il importe que de la lumière puisse être émise à travers la paroi circonférentielle, que celle-ci présente une forme polygonale ou circulaire par exemple.

Par ailleurs, la face terminale 14 peut présenter une forme sensiblement plane et perpendiculaire à la paroi circonférentielle, de sorte qu'elle s'étend sensiblement parallèlement à la face supérieure 13 du substrat 7, tel que cela est illustré sur la figure 2, ou bien elle peut présenter une forme bombée ou en pointe en son centre, de manière à multiplier les directions d'émission de la lumière sortant de cette face terminale.

Sur la figure 2, les bâtonnets électroluminescents 6 sont agencés en matrice à deux dimensions. Cet agencement pourrait être tel que les bâtonnets électroluminescents soient agencés en quinconce. L'invention couvre d'autres répartitions des bâtonnets, avec notamment des densités de bâtonnets qui peuvent être variables d'une source de lumière à l'autre, et qui peuvent être variables selon différentes zones d'une même source de lumière. On a représenté sur la figure 2 la distance de séparation d1 de deux bâtonnets électroluminescents immédiatement adjacents dans une première direction transversale et la distance de séparation d2 de deux bâtonnets électroluminescents immédiatement adjacents dans une deuxième direction transversale. Les distances de séparation d1 et d2 sont mesurées entre deux axes longitudinaux 11 de bâtonnets électroluminescents adjacents. Le nombre de bâtonnets électroluminescents 8 s'étendant en saillie du substrat 10 peut varier d'un dispositif à l'autre, notamment pour augmenter la densité lumineuse de la source de lumière, mais on convient que l'une et l'autre des distances de séparation d1, d2 sont de préférence inférieures ou égales à 30 micromètres.

La source de lumière peut comporter en outre, une couche (non représentée) d'un matériau polymère dans laquelle des bâtonnets électroluminescents 6 sont au moins partiellement noyés. La couche peut ainsi s'étendre sur toute l'étendue du substrat ou seulement autour d'un groupe déterminé de bâtonnets électroluminescents. Le matériau polymère, qui peut notamment être à base de silicone, permet de protéger les bâtonnets électroluminescents sans gêner la diffusion des rayons lumineux. En outre, il est possible d'intégrer dans cette couche de matériau polymère des moyens de conversion de longueur d'onde, et par exemple des luminophores, aptes à absorber au moins une partie des rayons émis par l'un des bâtonnets et à convertir au moins une partie de ladite lumière d'excitation absorbée en une lumière d'émission ayant une longueur d'onde différente de celle de la lumière d'excitation.

La source de lumière 5 comporte ici une forme rectangulaire, mais on comprendra qu'il peut présenter sans sortir du contexte de l'invention d'autres formes générales, et notamment une forme de parallélogramme.

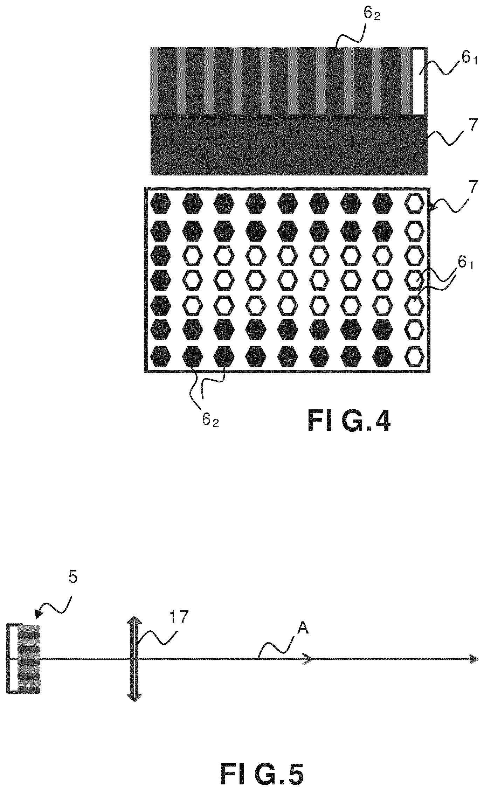

Selon l'invention, et comme plus particulièrement visible sur les deux exemples de configurations donnés aux figures 3 et 4, au moins certains bâtonnets 6, référencés 6₁ sur les figures, sont connectés électriquement entre eux en un premier ensemble dédié à une émission d'un faisceau lumineux à une première longueur d'onde, et d'autres bâtonnets, référencés 6₂ sont connectés électriquement entre eux en un deuxième ensemble dédié à une réception d'un faisceau lumineux à une deuxième longueur d'onde, le premier ensemble et le deuxième ensemble formant respectivement une zone d'émission et une zone de réception activables sélectivement.

Dans le cas de la figure 3, les deux ensembles sont complémentaires, en ce sens qu'ils ne se chevauchent pas.

Dans le cas de la figure 4, les bâtonnets 6₁ du premier ensemble et les bâtonnets 6₂ du deuxième ensemble sont agencés de sorte que le premier ensemble et le deuxième ensemble forment deux ensembles enchevêtrés, plus particulièrement imbriqués.

Les ensembles peuvent notamment être imbriqués de façon à ce que les barycentres géométriques respectifs du motif de leurs bâtonnets soient proches l'un de l'autre, typiquement d'une distance inférieure ou égale à 30 micromètres.

D'autres motifs pour les ensembles peuvent être adoptés, sans départir du cadre de la présente invention, à partir du moment où la source dispose bien d'un ensemble dédié à l'émission d'un faisceau lumineux, et d'un ensemble dédié à la réception d'un faisceau lumineux.

Les longueurs d'ondes sont quant à elles choisies en fonction de l'application recherchée. Ainsi, dans un mode de réalisation, la deuxième longueur d'onde est strictement supérieure à la première longueur d'onde, la deuxième longueur d'onde étant de préférence dans le spectre non visible. On peut ainsi par exemple réaliser un émetteur dans le rouge avec un capteur dans l'infrarouge.

Dans un autre mode de réalisation, la deuxième longueur d'onde est sensiblement égale à la première longueur d'onde.

On peut par exemple choisir la première longueur d'onde et la deuxième longueur d'onde dans le spectre visible.

En variante, la première longueur d'onde et la deuxième longueur d'onde sont choisies dans l'infrarouge, de préférence entre 780 nanomètres et 1,5 micromètres. L'arséniure de gallium (AsGa) émettra par exemple entre 860 et 870 nm et l'arséniure d'indium et de gallium (AsInGa) émettra par exemple entre 780 et 800 nanomètres.

Comme représenté schématiquement sur la figure 5, un système d'émission/réception de faisceaux lumineux, par exemple utilisé dans un dispositif d'éclairage et/ou de signalisation d'un véhicule automobile, comporte la source de lumière 5, notamment logée dans un boîtier fermé par une glace (non représentés) et qui définit un volume interne de réception de cette source de lumière associée à une optique de mise en forme 17. L'optique de mise en forme 17 est utilisée d'une part, à l'émission, pour imager à l'infini au moins une partie des rayons lumineux émis par la source de lumière, et d'autre part, à la réception de faisceaux lumineux. Au moins un des rayons émis par la source lumineuse est dévié par l'optique de mise en forme. On entend par dévié que la direction d'entrée du rayon lumineux dans l'optique de mise en forme est différente de la direction de sortie du rayon lumineux de l'optique de mise en forme. L'optique de mise en forme comprend au moins un élément optique tel qu'une ou plusieurs lentilles, un ou plusieurs réflecteurs, un ou plusieurs guides de lumière ou une combinaison de ces possibilités. L'optique 17 de mise en forme peut comprendre une optique de projection de la lumière émise par la source de lumière à semi-conducteur. Cette optique de projection crée une image réelle, et éventuellement anamorphosée, d'une partie du dispositif, par exemple la source elle-même ou un cache, ou d'une image intermédiaire de la source, à distance (finie ou infinie) très grande devant les dimensions du dispositif (d'un rapport de l'ordre d'au moins 30, de préférence 100) du dispositif. Cette optique de projection peut consister en un ou plusieurs réflecteurs, ou bien en une ou plusieurs lentilles, ou un ou plusieurs guides de lumière ou encore en une combinaison de ces possibilités.

Sur la figure 5, la source de lumière 5 est centrée sur l'axe optique A de la lentille convergente formant l'optique de projection adaptée pour imager la source de lumière à l'extérieur du véhicule. La source de lumière 5 est orientée de sorte les rayons qu'elle émet, à partir du premier ensemble, soient directement dirigés vers la lentille. L'optique 17 est également utilisée pour la mise en forme des faisceaux reçus par les bâtonnets du deuxième ensemble. Ainsi, la configuration particulière de la source permet d'utiliser un même système optique associé à la zone d'émission et à la zone de réception de ladite source de lumière.

Le système comporte en outre un dispositif de commande (non représenté) apte à activer indépendamment la zone d'émission et la zone de réception, en simultané et/ou en alternance, selon les applications recherchées.

Dans une application possible, le système selon l'invention peut être utilisé pour l'échange de signaux de communication, en particulier en Li-Fi, par exemple avec un dispositif communicant, notamment une tablette électronique, dotés de fonctionnalités d'émission et/ou de réception de tels signaux de communication. Dans ce cas, les bâtonnets du premier ensemble sont connectés entre eux et commandés de façon à pouvoir émettre des signaux de communications, et les bâtonnets du deuxième ensemble sont connectés entre eux et commandés de façon à pouvoir recevoir des signaux de communication.

Le dispositif d'éclairage et/ou de signalisation recevant un tel système peut être avantageusement un plafonnier dans l'habitacle d'un véhicule automobile.

Dans une autre application, on peut prévoir d'intégrer le système dans un projecteur ou un feu arrière de signalisation d'un véhicule automobile. Des signaux de communication, par exemple en Li-Fi, peuvent ainsi être échangés avec un autre véhicule automobile équipé lui aussi d'un tel système, et/ou avec des infrastructures telles que des panneaux ou feux tricolores.

Le système peut également être utilisé comme capteur de différents objets ou conditions environnem entales, et servir notamment:
- de capteur de pluie ;
- de capteur de luminosité ambiante ;
- de capteur de visibilité ;
- de capteur de salissure (sur la glace du projecteur ou du feu).

## Revendications

1. Source (5) de lumière à semi-conducteur comprenant une pluralité de sources à semi-conducteur en trois dimensions (6₁,6₂) de dimensions submillimétriques, dans laquelle au moins certaines sources à semi-conducteur en trois dimensions (6₁) sont connectées électriquement entre elles en un premier ensemble dédié à une émission d'un faisceau lumineux sensiblement à une première longueur d'onde, et d'autres sources à semi-conducteur en trois dimensions (6₂) sont connectées électriquement entre elles en un deuxième ensemble dédié à une réception d'un faisceau lumineux sensiblement à une deuxième longueur d'onde, le premier ensemble et le deuxième ensemble formant respectivement une zone d'émission et une zone de réception distinctes, et dans laquelle les sources à semi-conducteur en trois dimensions sont sur un même substrat.

2. Source (5) de lumière selon la revendication 1, dans laquelle la deuxième longueur d'onde est strictement supérieure à la première longueur d'onde, la deuxième longueur d'onde étant de préférence dans le spectre non visible.

3. Source (5) de lumière selon la revendication 1, dans laquelle la deuxième longueur d'onde est sensiblement égale à la première longueur d'onde.

4. Source (5) de lumière selon l'une quelconque des revendications précédentes, dans laquelle la première longueur d'onde et la deuxième longueur d'onde sont choisies dans le spectre visible.

5. Source (5) de lumière selon l'une quelconque des revendications 1 à 3, dans laquelle la première longueur d'onde et la deuxième longueur d'onde sont choisies dans l'infrarouge, de préférence entre 780 nanomètres et 1,5 micromètres.

6. Source (5) de lumière selon l'une quelconque des revendications précédentes, dans laquelle les sources à semi-conducteur en trois dimensions (6₁) du premier ensemble et les sources à semiconducteur en trois dimensions (6₂) du deuxième ensemble sont réparties de sorte que le premier ensemble et le deuxième ensemble forment deux zones enchevêtrées.

7. Source (5) de lumière selon l'une quelconque de revendications précédentes, dans laquelle lesdites sources à semi-conducteur à trois dimensions sont séparées deux à deux d'une distance inférieure ou égale à 30 microns.

8. Système d'émission/réception de faisceaux lumineux, comportant au moins une source de lumière selon l'une quelconque des revendications 1 à 7, et une même optique de mise en forme associée à la zone d'émission et à la zone de réception de ladite source de lumière.

9. Système selon la revendication 8, dans lequel ladite au moins une source de lumière et l'optique de mise en forme associée sont placés dans un dispositif d'éclairage et/ou de signalisation d'un véhicule automobile, et en ce que le système comporte en outre un dispositif de commande apte à activer indépendamment la zone d'émission et la zone de réception, en simultané et/ou en alternance.

10. Système selon la revendication 9, dans lequel les sources à semi-conducteur en trois dimensions (6₁, 6₂) du premier ensemble, respectivement du deuxième ensemble, sont aptes à émettre, respectivement recevoir, des signaux de communication.

11. Système selon la revendication 10, dans lequel le dispositif d'éclairage et/ou de signalisation est un plafonnier dans l'habitacle d'un véhicule automobile.

12. Système selon l'une quelconque des revendications 8 à 10, dans lequel le dispositif d'éclairage et/ou de signalisation est un projecteur, un feu de signalisation ou un feu arrière de signalisation d'un véhicule automobile.

13. Système selon la revendication 12, dans lequel les sources à semi-conducteur en trois dimensions (6₁, 6₂) du premier ensemble, respectivement du deuxième ensemble, sont aptes à émettre, respectivement recevoir, des signaux de communication avec un autre véhicule automobile.

## Patentansprüche

1. Halbleiterlichtquelle (5), die eine Vielzahl von dreidimensionalen Halbleiterquellen (6₁, 6₂) mit Abmessungen im Submillimeterbereich beinhaltet, wobei mindestens einige dreidimensionale Halbleiterquellen (6₁) untereinander zu einem ersten Satz elektrisch verbunden sind, der für die Ausstrahlung eines Lichtstrahls mit im Wesentlichen einer ersten Wellenlänge gedacht ist, und andere dreidimensionale Halbleiterquellen (6₂) untereinander zu einem zweiten Satz elektrisch verbunden sind, der für den Empfang eines Lichtstrahls mit im Wesentlichen einer zweiten Wellenlänge gedacht ist, wobei der erste Satz und der zweite Satz jeweils einen getrennten Ausstrahlungsbereich und Empfangsbereich bilden und wobei sich die dreidimensionalen Halbleiterquellen auf einem gemeinsamen Substrat befinden.

2. Lichtquelle (5) nach Anspruch 1, wobei die zweite Wellenlänge in jedem Fall größer als die erste Wellenlänge ist, wobei die zweite Wellenlänge vorzugsweise im nicht sichtbaren Spektrum liegt.

3. Lichtquelle (5) nach Anspruch 1, wobei die zweite Wellenlänge im Wesentlichen gleich der ersten Wellenlänge ist.

4. Lichtquelle (5) nach einem der vorhergehenden Ansprüche, wobei die erste Wellenlänge und die zweite Wellenlänge aus dem sichtbaren Spektrum ausgewählt sind.

5. Lichtquelle (5) nach einem der Ansprüche 1 bis 3, wobei die erste Wellenlänge und die zweite Wellenlänge aus dem Infrarotbereich ausgewählt sind, vorzugsweise aus dem Bereich zwischen 780 Nanometern und 1,5 Mikrometern.

6. Lichtquelle (5) nach einem der vorhergehenden Ansprüche, wobei die dreidimensionalen Halbleiterquellen (6₁) des ersten Satzes und die dreidimensionalen Halbleiterquellen (6₂) des zweiten Satzes so verteilt sind, dass der erste Satz und der zweite Satz zwei ineinander verschachtelte Bereiche bilden.

7. Lichtquelle (5) nach einem der vorhergehenden Ansprüche, wobei die dreidimensionalen Halbleiterquellen paarweise um einen Abstand voneinander getrennt sind, der kleiner als oder gleich 30 Mikrometer ist.

8. Ausstrahlungs-/Empfangssystem für Lichtstrahlen, das mindestens eine Lichtquelle nach einem der Ansprüche 1 bis 7 und eine gemeinsame Formungsoptik umfasst, die mit dem Ausstrahlungsbereich und dem Empfangsbereich der Lichtquelle assoziiert ist.

9. System nach Anspruch 8, wobei die mindestens eine Lichtquelle und die assoziierte Formungsoptik in einer Beleuchtungs- und/oder Signalisierungsvorrichtung eines Kraftfahrzeugs untergebracht sind, und dass das System ferner eine Steuervorrichtung umfasst, die dazu fähig ist, den Ausstrahlungsbereich und den Empfangsbereich unabhängig voneinander simultan und/oder im Wechsel zu aktivieren.

10. System nach Anspruch 9, wobei die dreidimensionalen Halbleiterquellen (6₁, 6₂) des ersten Satzes bzw. des zweiten Satzes dazu fähig sind, Kommunikationssignale auszustrahlen bzw. zu empfangen.

11. System nach Anspruch 10, wobei die Beleuchtungs- und/oder Signalisierungsvorrichtung eine Deckenleuchte in der Fahrgastzelle eines Kraftfahrzeugs ist.

12. System nach einem der Ansprüche 8 bis 10, wobei die Beleuchtungs- und/oder Signalisierungsvorrichtung ein Scheinwerfer, eine Signalisierungsleuchte oder eine hintere Signalisierungsleuchte eines Kraftfahrzeugs ist.

13. System nach Anspruch 12, wobei die dreidimensionalen Halbleiterquellen (6₁, 6₂) des ersten Satzes bzw. des zweiten Satzes dazu fähig sind, Kommunikationssignale zu einem anderen Kraftfahrzeug auszustrahlen bzw. von diesem zu empfangen.

## Claims

1. Semiconductor light source (5) comprising a plurality of three-dimensional semiconductor sources (6₁, 6₂) of submillimetric dimensions, wherein at least some three-dimensional semiconductor sources (6₁) are connected electrically to one another into a first set dedicated to an emission of a light beam substantially at a first wavelength, and other three-dimensional semiconductor sources (6₂) are connected electrically to one another into a second set dedicated to a reception of a light beam substantially at a second wavelength, the first set and the second set respectively forming an emission zone and a reception zone that are distinct, and wherein the three-dimensional semiconductor sources are on a same substrate.

2. Light source (5) according to Claim 1, wherein the second wavelength is strictly greater than the first wavelength, the second wavelength being preferably in the non-visible spectrum.

3. Light source (5) according to Claim 1, wherein the second wavelength is substantially equal to the first wavelength.

4. Light source (5) according to any one of the preceding claims, wherein the first wavelength and the second wavelength are chosen in the visible spectrum.

5. Light source (5) according to any one of Claims 1 to 3, wherein the first wavelength and the second wavelength are chosen in the infrared, preferably between 780 nanometres and 1.5 micrometres.

6. Light source (5) according to any one of the preceding claims, wherein the three-dimensional semiconductor sources (6₁) of the first set and the three-dimensional semiconductor sources (6₂) of the second set are distributed in such a way that the first set and the second set form two interlocked zones.

7. Light source (5) according to any one of the preceding claims, wherein said three-dimensional semiconductor sources are separated pairwise by a distance less than or equal to 30 microns.

8. Light beam emission/reception system, comprising at least one light source according to any one of Claims 1 to 7, and a same forming optic associated with the emission zone and with the reception zone of said light source.

9. System according to Claim 8, wherein said at least one light source and the associated forming optic are placed in a lighting and/or signalling device of a motor vehicle, and in that the system further comprises a control device capable of independently activating the emission zone and the reception zone, simultaneously and/or alternatively.

10. System according to Claim 9, wherein the three-dimensional semiconductor sources (6₁, 6₂) of the first set, respectively of the second set, are capable of emitting, respectively receiving, communication signals.

11. System according to Claim 10, wherein the lighting and/or signalling device is a dome light in the interior of a motor vehicle.

12. System according to any one of Claims 8 to 10, wherein the lighting and/or signalling device is a headlight, a signalling light or a rear signalling light of a motor vehicle.

13. System according to Claim 12, wherein the three-dimensional semiconductor sources (6₁, 6₂) of the first set, respectively of the second set, are capable of emitting, respectively receiving, communication signals with another motor vehicle.
